# EUROPEAN PATENT SPECIFICATION

(11) **EP 3 188 275 B1**
(45) Date of publication and mention of the grant of the patent: **22.12.2021**
(21) Application number: 16206389.5
(22) Date of filing: 22.12.2016
(51) Int. Cl.: H01L 51/52

(54) **ORGANIC LIGHT EMITTING DISPLAY DEVICE**
ORGANISCHE LICHTEMITTIERENDE ANZEIGEVORRICHTUNG
AFFICHEUR ÉLECTROLUMINESCENT ORGANIQUE

(30) Priority: 31.12.2015 KR 20150190595
(43) Date of publication of application: 05.07.2017
(73) Proprietor: LG Display Co., Ltd., Seoul, 07336 (KR)
(72) Inventor: KIM, Dongjin, Seoul 03310 (KR)
(74) Representative: Morrall, Jonathan Ian McLachlan

(56) References cited:
- WO-A1-2008/102866
- WO-A1-2015/000095
- JP-A- 2004 258 487
- JP-A- 2008 010 450
- US-A1- 2003 017 777
- US-A1- 2007 027 571
- US-A1- 2011 121 352
- US-A1- 2014 176 932
- US-A1- 2014 184 059
- US-A1- 2015 263 309

## Description

### CROSS-REFERENCE TO RELATED APPLICATIONS

This application claims the benefit of the Korean Patent Application No. 10-2015-0190595 filed on December 31, 2015.

### BACKGROUND

### Field of the Invention

The present invention relates to an organic light emitting display device, and more particularly, to an align mark necessary for a scribing process which is performed for obtaining a plurality of unit panels from a mother substrate.

### Discussion of the Related Art

Organic light emitting display devices are display devices that self-emit light, and have a structure where an organic emission layer is formed between a cathode and an anode. Due to the structure, an electron supplied from the cathode and a hole supplied from the anode are injected into the organic emission layer to generate an exciton, and the generated exciton is shifted from an excited state to a ground state to emit light.

The organic light emitting display devices are obtained through a process where a plurality of unit panels (U/P) are provided on a mother substrate and then are cut through a scribing process. Hereinafter, a related art organic light emitting display device will be described with reference to the drawings.

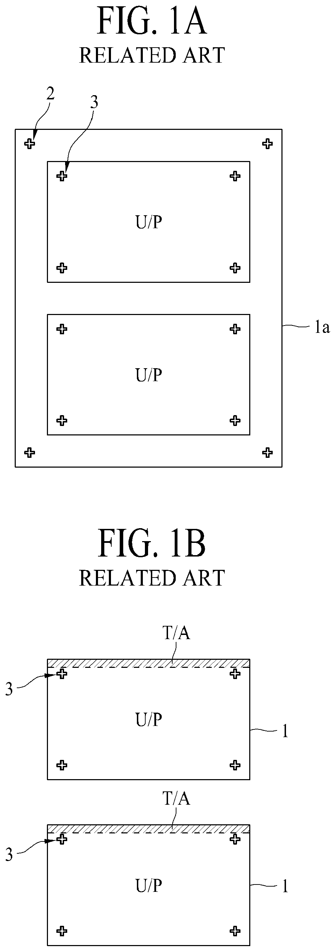

FIGS. 1A to 1C are schematic process views illustrating a process of manufacturing a related art organic light emitting display device.

First, as seen in FIG. 1A, a plurality of unit panels U/P are provided on a mother substrate 1a. In the drawings, for convenience, only two unit panels U/P are illustrated.

A first align mark 2 for a first scribing process is formed in an edge area of the mother substrate 1a, and a second align mark 3 for a second scribing process is formed in each of the plurality of unit panels U/P.

Subsequently, as seen in FIG. 1B, the first scribing process is performed by using the first align mark 2 formed in the edge area of the mother substrate 1a. Accordingly, the plurality of unit panels U/P are obtained.

In this case, a test area T/A is provided in each of the plurality of unit panels U/P, and thus, a test process is performed for each of the unit panels U/P.

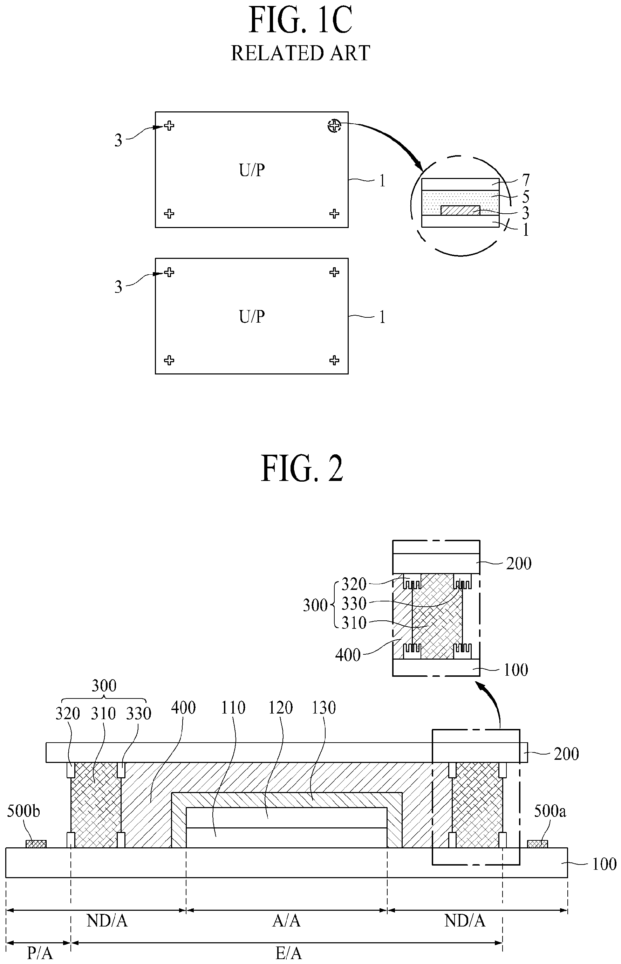

Subsequently, as seen in FIG. 1C, the second scribing process is performed by using the second align mark 3 formed in an edge area of each of the unit panels U/P. Accordingly, the test area T/A is removed from the each of the unit panels U/P.

As described above, the related art organic light emitting display device is manufactured through the first scribing process using the first align mark 2 and the second scribing process using the second align mark 3. However, the second align mark 3 is not easily distinguished in the second scribing process, and for this reason, the second scribing process is not smoothly performed.

In FIG. 1C, an enlarged portion referred to by an arrow corresponds to a cross-sectional surface of an area where the second align mark 3 is formed. In this case, the second align mark 3 is formed on a substrate 1, an encapsulation layer 5 for preventing penetration of water is formed on the second align mark 3, and an encapsulation substrate 7 is provided on the encapsulation layer 5.

As described above, in the related art, since the encapsulation layer 5 is formed on the second align mark 3, the second align mark 3 is not easily distinguished, and for this reason, the second scribing process for removing the test area T/A from each of the unit panels U/P is not easily performed.

US2003/0017777 A1 and US2014/0176932 A1 both show a rounded dam structure as the third dam structure and an alignment mark outside and adjacent to the rounded dam structure.

### SUMMARY

Accordingly, the present invention is directed to provide an organic light emitting display device that substantially obviates one or more problems due to limitations and disadvantages of the related art.

An aspect of the present invention is directed to provide an organic light emitting display device in which an align mark is easily distinguished, and thus, a scribing process is smoothly performed.

Additional advantages and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these and other advantages and in accordance with the invention, there is provided an organic light emitting display device comprising: a substrate including an active area and a non-display area provided outside the active area; and a dam structure disposed in a non-display area of a substrate. The dam structure includes a first dam structure extending in a first direction, a second dam structure extending in a second direction, and a third dam structure extending between and connecting the first dam structure and the second dam structure, wherein the first dam structure and the second dam structure are arranged in parallel with outermost lines of the active area, and the third structure is not arranged in parallel with the outermost lines of the active area. The first align mark is disposed outside the third dam structure, the first align mark adjacent the third dam structure and formed on or inward from an extension line of the first dam structure or an extension line of the second dam structure.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the invention. In the drawings:
FIGS. 1A to 1C are schematic process views illustrating a process of manufacturing a related art organic light emitting display device;
FIG. 2 is a schematic cross-sectional view of an organic light emitting display device;
FIG. 3 is a schematic plan view of an organic light emitting display device;
FIG. 4 is a plan view of an organic light emitting display device and is an enlarged view of a C area of FIG. 3;
FIGS. 5A and 5B are schematic views illustrating a disposed position of a first align mark;
FIG. 6 is a plan view of an organic light emitting display device;
FIG. 7 is a plan view of an organic light emitting display device;
FIG. 8 is a schematic plan view of an organic light emitting display device;
FIG. 9 is a schematic plan view of an organic light emitting display device; and
FIG. 10 is a schematic plan view of an organic light emitting display device.

### DETAILED DESCRIPTION OF THE INVENTION

Reference will now be made in detail to the exemplary embodiments, examples of which are illustrated in the accompanying drawings. Wherever possible, the same reference numbers will be used throughout the drawings to refer to the same or like parts.

Advantages and features of the present invention, and implementation methods thereof will be clarified through following embodiments described with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. Further, the present invention is only defined by scopes of claims.

A shape, a size, a ratio, an angle, and a number disclosed in the drawings are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted. In a case where 'comprise', 'have', and 'include' described in the present specification are used, another part may be added unless 'only~' is used. The terms of a singular form may include plural forms unless referred to the contrary.

In construing an element, the element is construed as including an error range although there is no explicit description.

In describing a position relationship, for example, when a position relation between two parts is described as 'on~', 'over~', 'under~', and 'next~', one or more other parts may be disposed between the two parts unless 'just' or 'direct' is used.

In describing a time relationship, for example, when the temporal order is described as 'after~', 'subsequent~', 'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Features of various embodiments of the present disclosure may be partially or overall coupled to or combined with each other, and may be variously inter-operated with each other and driven technically as those skilled in the art can sufficiently understand. The embodiments of the present invention may be carried out independently from each other, or may be carried out together in co-dependent relationship.

Hereinafter, embodiments will be described in detail with reference to the accompanying drawings.

FIG. 2 is a schematic cross-sectional view of an organic light emitting display device.

As seen in FIG. 2, the organic light emitting display device includes a first substrate 100, a dam structure 300 and a plurality of align marks 500a and 500b and may include a second substrate 200 and a filler 400.

The first substrate 100 may be formed of glass or transparent plastic. An active area A/A, a non-display area ND/A, a pad area P/A, and an encapsulation area E/A may be provided on the first substrate 100.

A plurality of pixels P are provided in the active area A/A, thereby displaying an image. In order to display an image, a circuit device layer 110 and an emission device layer 120 may be disposed in the active area A/A on the first substrate 100.

The circuit device layer 110 may be formed on the first substrate 100, and although not shown in detail, the circuit device layer 110 may include a gate line, a data line, a power line, a switching thin film transistor (TFT), a driving TFT, and a capacitor. A detailed configuration of the circuit device layer 110 may be modified into various types well known to those skilled in the art.

The emission device layer 120 may be formed on the circuit device layer 110, and although not shown in detail, the emission device layer 120 may include a bank layer, an anode, a cathode, and an organic emission layer disposed between the anode and the cathode. A detailed configuration of the emission device layer 120 may be modified into various types well known to those skilled in the art.

The non-display area ND/A is an area that cannot display an image, and is provided outside the active area A/A.

The pad area P/A may be disposed in the non-display area ND/A. A plurality of signal pads connected to an external driver may be disposed in the pad area P/A. Therefore, the external driver may be connected to the signal pads disposed in the pad area P/A and may apply signals to the active area A/A. In this manner, the pad area P/A may be exposed to the outside so as to be connected to the external driver. That is, in order for the pad area P/A provided on the first substrate 100 to be exposed to the outside, the second substrate 200 may be shorter in length than the first substrate 100, and moreover, the encapsulation area E/A may not extend to the pad area P/A.

The encapsulation area E/A prevents water from penetrating into the active area A/A. In order to prevent penetration of water, a passivation layer 130 may be disposed on the emission device layer 120, the filler 400 may be disposed on the passivation layer 130, and the dam structure 300 may be disposed outside the filler 400. Therefore, an area where the passivation layer 130, the filler 400, and the dam structure 300 are disposed may correspond to the encapsulation area E/A. As a result, the encapsulation area E/A may include the active area A/A, an area where the dam structure 300 is disposed, and an area therebetween.

The passivation layer 130 may be formed on the emission device layer 120 and may cover the emission device layer 120 and the circuit device layer 110. That is, the passivation layer 130 may cover a top and a side surface of the emission device layer 120 and a side surface of the circuit device layer 110. The passivation layer 130 may include an inorganic insulating material such as silicon oxide, silicon nitride, and/or the like, and particularly, may have a structure where different inorganic insulating materials are alternately stacked.

The filler 400 may be formed on the passivation layer 130, and particularly, may be filled between the first substrate 100 and the second substrate 200. The filler 400 may include a transparent material for preventing penetration of water. Also, the filler 400 may further include an adhesive material, thereby enhancing an adhesive force between the first substrate 100 and the second substrate 200. The filler 400 may extend from the active area A/A to the non-display area ND/A, and particularly, may extend to the inside of the dam structure 300.

The dam structure 300 may be disposed between the first substrate 100 and the second substrate 200 and may bond the first substrate 100 to the second substrate 200. An area between the first substrate 100 and the second substrate 200 may be sealed by the dam structure 300. Also, the dam structure 300 may define the encapsulation area E/A, and thus, an internal area of the dam structure 300 may correspond to the encapsulation area E/A.

The dam structure 300 may include a sealant 310, an outer dam bank or structure 320, and an inner dam bank or structure 330.

The sealant 310 may bond the first substrate 100 to the second substrate 200. The sealant 310 may be formed of various materials, well known to those skilled in the art, such as a thermocurable resin, a photocurable resin, and/or the like.

The outer dam bank 320 and the inner dam bank 330 may be respectively disposed outside and inside the sealant 310 to define a coating area where the sealant 310 is coated. The outer dam bank 320 and the inner dam bank 330 may be formed of the same material as that of a bank layer for defining a pixel area in the emission device layer 120 through the same process as the bank layer. For example, the outer dam bank 320 and the inner dam bank 300 may be formed of an organic insulating material such as polyimide, photo acryl, benzocyclobutene (BCB), and/or the like.

The align marks 500a and 500b may not be covered by the sealant 310 due to the outer dam bank 320, for preventing the sealant 310 from spreading to the outside. Also, the active area A/A may not be covered by the sealant 310 due to the inner dam bank 330, for preventing the sealant 310 from spreading to the inside.

As seen in the enlarged portion referred to by an arrow in FIG. 2, the outer dam bank 320 and the inner dam bank 330 may have a concave-convex structure. If the outer dam bank 320 and the inner dam bank 330 have the concave-convex structure, the sealant 310 is more efficiently prevented from spreading to the inside and the outside. Only one of the outer dam bank 320 and the inner dam bank 330 may have the concave-convex structure.

The outer dam bank 320 and the inner dam bank 330, as illustrated, may be formed on each of the first substrate 100 and the second substrate 200, but are not limited thereto. In other embodiments, the outer dam bank 320 may be formed on only one of the first substrate 100 and the second substrate 200, and the inner dam bank 330 may be formed on only one of the first substrate 100 and the second substrate 200.

The align marks 500a and 500b are disposed on the first substrate 100. The align marks 500a and 500b may be formed of the same material as that of an element of the circuit device layer 110 on the first substrate 100 through the same process. For example, the align marks 500a and 500b may be formed of the same material as that of the gate line of the circuit device layer 110 through the same process, or may be formed of the same material as that of the data line of the circuit device layer 110 through the same process.

The align marks 500a and 500b are disposed in the non-display area ND/A. The align marks 500a and 500b include a first align mark 500a, disposed in a portion of the non-display area ND/A which does not overlap the pad area P/A, and may include a second align mark 500b which may be disposed in another portion of the non-display area ND/A overlapping the pad area P/A. That is, the second align mark 500b may be disposed in the pad area P/A, and the first align mark 500a is disposed in the non-display area ND/A excluding the pad area P/A.

The first align mark 500a and the second align mark 500b are disposed outside the dam structure 300. In more detail, the first align mark 500a and the second align mark 500b are disposed outside the outer dam bank 320. As described above, since the first align mark 500a and the second align mark 500b are disposed outside the dam structure 300, the first align mark 500a and the second align mark 500b are not covered by an encapsulating material such as the dam structure 300 or the filler 400 provided in the encapsulation area E/A, and thus, a scribing process is smoothly performed.

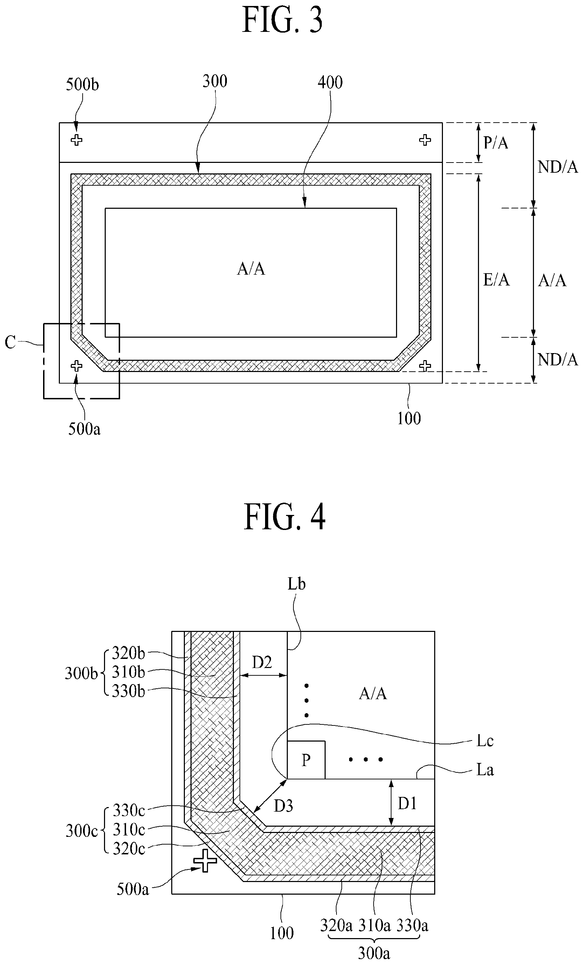

FIG. 3 is a schematic plan view of an organic light emitting display device.

As seen in FIG. 3, an active area A/A is provided on a first substrate 100, and a non-display area ND/A is provided outside the active area A/A. Also, the non-display area ND/A may include a pad area P/A.

A dam structure 300 is disposed in the non-display area ND/A, and a filler 400 may be disposed inside the dam structure 300. The dam structure 300 is disposed to surround the active area A/A, and the filler 400 may be provided to extend from the active area A/A to the inside of the dam structure 300. In order for the pad area P/A to be exposed, the dam structure 300 may not be provided in the pad area P/A. Therefore, an encapsulation area E/A which includes the dam structure 300 and the filler 400 may be provided in the active area A/A and a partial region of the non-display area ND/A, but may not be provided in the pad area P/A.

A plurality of align marks 500a and 500b may be formed outside the dam structure 300. The align marks 500a and 500b may be disposed in an edge area of the first substrate 100. The align marks 500a and 500b include a first align mark 500a and may include a second align mark 500b. As described above, the first align mark 500a is disposed in a portion of the non-display area ND/A which does not overlap the pad area P/A, and the second align mark 500b may be disposed in another portion of the non-display area ND/A overlapping the pad area P/A.

Since the dam structure 300 is not disposed in the pad area P/A, the second align mark 500b disposed in the pad area P/A does not overlap the dam structure 300, and thus, is not covered by the dam structure 300. However, since the first align mark 500a and the dam structure 300 are disposed in the non-display area ND/A excluding the pad area P/A, there is a possibility that the first align mark 500a can overlap the dam structure 300, and thus, can be covered by the dam structure 300.

In an embodiment, by modifying a shape of the dam structure 300, the dam structure 300 does not overlap the first align mark 500a, and thus, the first align mark 500a is not covered by the dam structure 300, thereby enabling the scribing process to be smoothly performed.

In detail, the dam structure 300 is wholly formed outside the active area A/A to have a shape corresponding to the active area A/A, but in an area (see a C area) where the first align mark 500a is disposed, the dam structure 300 does not have the shape corresponding to the active area A/A. That is, if the active area A/A has a rectangular structure, the dam structure 300 may wholly have the rectangular structure, but in an edge area (see the C area) of the first substrate 100 where the first align mark 500a is disposed, the dam structure 300 may not have an edge formed at a right angle.

The edge area (see the C area) of the first substrate 100 where the first align mark 500a is disposed will be described below in detail.

FIG. 4 is a plan view of an organic light emitting display device and is an enlarged view of the C area of FIG. 3.

As seen in FIG. 4, the dam structure 300 includes a first dam structure 300a, a second dam structure 300b, and a third dam structure 300c.

The first dam structure 300a is arranged in a first-direction, for example, a horizontal direction to have a rectilinear structure. The first dam structure 300a is arranged in parallel with an outermost line La of the active area A/A in the first direction. The first dam structure 300a may include a first sealant 310a, a first outer dam bank 320a, and a first inner dam bank 330a. The first sealant 310a, the first outer dam bank 320a, and the first inner dam bank 330a may all be arranged in parallel with the outermost line La of the active area A/A in the first direction. Particularly, the first inner dam bank 330a may be spaced apart from the outermost line La of the active area A/A in the first direction by a first distance D1.

The second dam structure 300b is arranged in a second-direction, for example, a vertical-direction to have a rectilinear structure. The second dam structure 300b is arranged in parallel with an outermost line Lb of the active area A/A in the second direction. The second dam structure 300b may include a second sealant 310b, a second outer dam bank 320b, and a second inner dam bank 330b. The second sealant 310b, the second outer dam bank 320b, and the second inner dam bank 330b may all be arranged in parallel with the outermost line Lb of the active area A/A in the second direction. Particularly, the second inner dam bank 330b may be spaced apart from the outermost line Lb of the active area A/A in the second direction by a second distance D2.

The third dam structure 300c may have a rectilinear structure. The third dam structure 300c connects the first dam structure 300a to the second dam structure 300b. The third dam structure 300c is slopingly connected to the first dam structure 300a and the second dam structure 300b. The third dam structure 300c is arranged not to be parallel to the outermost line La of the active area A/A in the first direction and the outermost line Lb of the active area A/A in the second direction. Therefore, due to the third dam structure 300c, a shape of the dam structure 300 differs from that of the active area A/A. The third dam structure 300c may include a third sealant 310c, a third outer dam bank 320c, and a third inner dam bank 330c. The third sealant 310c, the third outer dam bank 320c, and the third inner dam bank 330c may all be arranged not to be parallel to the outermost line La of the active area A/A in the first direction and the outermost line Lb of the active area A/A in the second direction. The third inner dam bank 330c may be spaced apart from an outermost line (in detail, a vertex Lc at which the outermost line La in the first direction meets the outermost line Lb in the second direction) of the active area A/A by a third distance D3.

The third sealant 310c may be connected to each of the first sealant 310a and the second sealant 310b. In detail, one end of the third sealant 310c may be connected to the first sealant 310a, and the other end of the third sealant 310c may be connected to the second sealant 310b.

The third outer dam bank 320c may be connected to each of the first outer dam bank 320a and the second outer dam bank 320b. In detail, one end of the third outer dam bank 320c may be connected to the first outer dam bank 320a, and the other end of the third outer dam bank 320c may be connected to the second outer dam bank 320b.

The third inner dam bank 330c may be connected to each of the first inner dam bank 330a and the second inner dam bank 330b. In detail, one end of the third inner dam bank 330c may be connected to the first inner dam bank 330a, and the other end of the third inner dam bank 330c may be connected to the second inner dam bank 330b.

As described above, the third dam structure 300c is slopingly connected to each of the first and second dam structures 300a and 300b (for example, connected at an angle between the first and second dam structures 300a and 300b), and an area where a first align mark 500a is formed to be provided in an area outside the third dam structure 300c. In the inventive example, the first alignment mark 500a is adjacent the third dam structure 500c and formed on or inward from an extension line of the first dam structure 300a or from an extension line of the second dam structure 300b . Therefore, the first align mark 500a is prevented from overlapping the dam structure 300b even without any increase in size of the non-display area ND/A. Accordingly, a bezel size of the organic light emitting display device is reduced, and moreover, the scribing process is smoothly performed.

Moreover, a first distance D1 between the first inner dam bank 330a and the active area A/A, a second distance D2 between the second inner dam bank 330b and the active area A/A, and a third distance D3 between the third inner dam bank 330c and the active area A/A may be appropriately maintained, and thus, the active area A/A is not covered by the dam structure 300. Particularly, if the third distance D3 is reduced, the area where the first align mark 500a is formed is enlarged, but if the third distance D3 is too reduced, the active area A/A is covered by the third sealant 310c of the third dam structure 300c. Accordingly, when the third distance D3 is adjusted to be equal to or greater than the first distance D1 or the second distance D2, the active area A/A is not covered by the third sealant 310c.

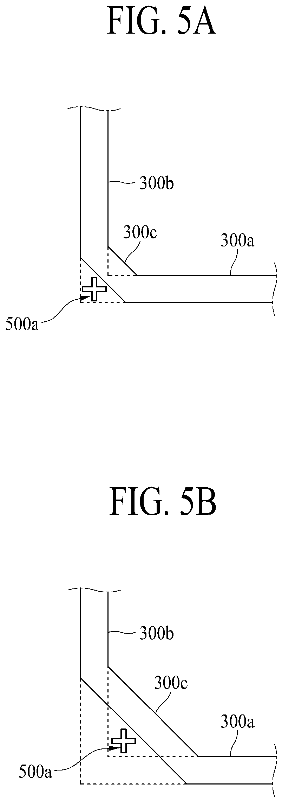

FIGS. 5A and 5B are schematic views illustrating a disposed position of a first align mark in an inventive example.

As seen in FIG. 5A, a first align mark 500a disposed outside a third dam structure 300c is formed on an extension line of a first dam structure 300a or an extension line of a second dam structure 300b.

As seen in FIG. 5B, a first align mark 500b disposed outside a third dam structure 300c is formed inward from an extension line of a first dam structure 300a or an extension line of a second dam structure 300b.

As described above, since the first align mark 500a is formed on or inward from the extension line of the first/second dam structure 300a/300b, a non-display area is reduced, and thus, a bezel size of an organic light emitting display device is largely reduced.

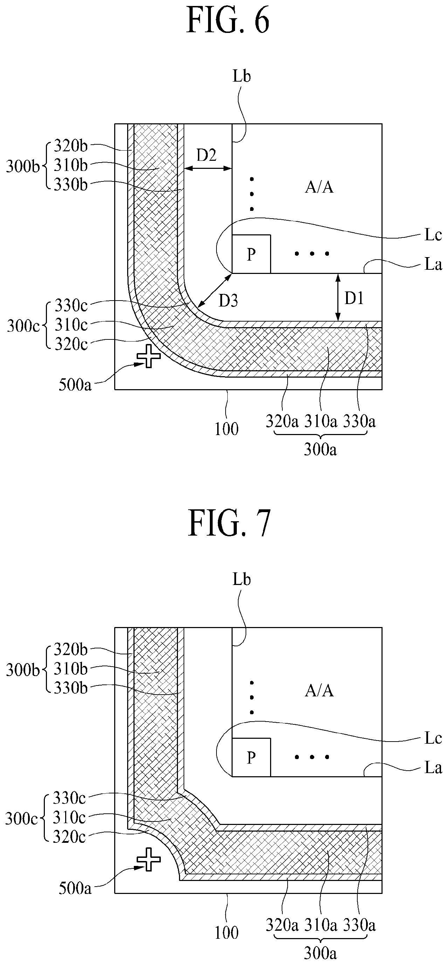

FIGS. 6 and 7 are plan views of an organic light emitting display device. Except that a structure of a third dam structure 300c is modified, the organic light emitting display device illustrated in FIGS. 6 and 7 is the same as the organic light emitting display device illustrated in FIG. 4. Therefore, like reference numerals refer to like elements. Hereinafter, only different elements will be described.

According to the embodiment of FIG. 4, the third dam structure 300c may have the rectilinear structure. According to the embodiments of FIGS. 6 and 7, however, a third dam structure 300c may have a curve structure.

Particularly, in FIG. 6, a center point of a curve structure of a third dam structure 300c may be disposed inward from the third dam structure 300c, and thus, the curve structure of the third dam structure 300c may be a structure which is convex in an outer direction. In this case, a distance D3 between the third dam structure 300c and an outermost line Lc of an active area A/A is sufficiently secured.

Moreover, in FIG. 7, a center point of a curve structure of a third dam structure 300c may be disposed outward from the third dam structure 300c, and thus, the curve structure of the third dam structure 300c may be a structure which is convex in an inner direction. In this case, an area where a first align mark 500a disposed outside the third dam structure 300c is formed is sufficiently secured.

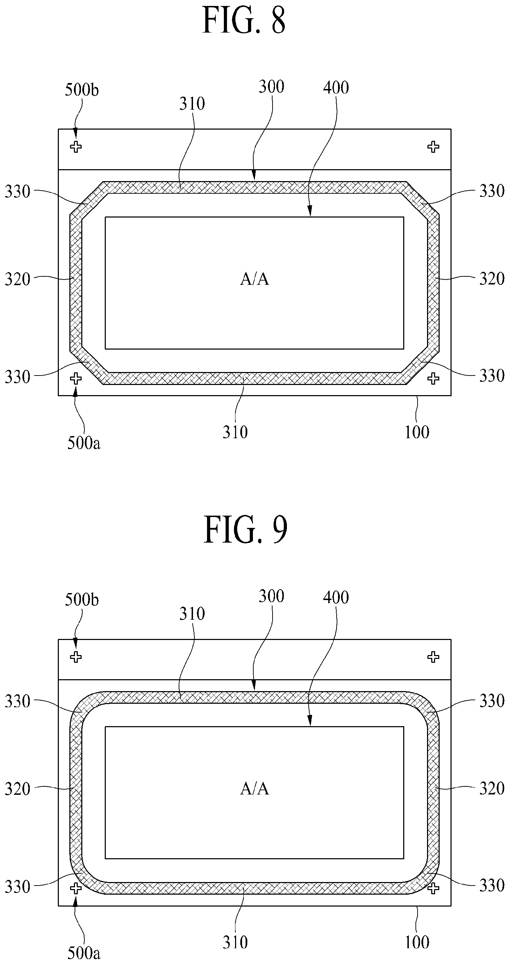

FIG. 8 is a schematic plan view of an organic light emitting display device. Except that a structure of a dam structure 300 is modified, the organic light emitting display device illustrated in FIG. 8 is the same as the organic light emitting display device illustrated in FIG. 3. Therefore, like reference numerals refer to like elements. Hereinafter, only different elements will be described.

As seen in FIG. 8, a dam structure 300 may include two first dam structures 300a that are arranged in a first-direction to have a rectilinear structure, two second dam structures 300b that are arranged in a second-direction to have a rectilinear structure, and four third dam structures 300c that have a rectilinear structure, are inclined with respect to the first dam structures 300a and the second dam structures 300b, and connect the first dam structures 300a to the second dam structures 300b.

In the above-described structure of FIG. 3, the third dam structure 300c is disposed near the first align mark 500a, but the third dam structure 300c may not be disposed near the second align mark 500b. Therefore, in a portion near the second alignment mark 500b, the first dam structure 300a and the second dam structure 300b may be directly connected to each other and may have a shape corresponding to an outermost line of an active area A/A.

On the other hand, according to the embodiment of FIG. 8, a third dam structure 300c is disposed near a first align mark 500a, and moreover, the third dam structure 300c may be disposed near a second align mark 500b. Therefore, a possibility that the second align mark 500b disposed in a pad area P/A can be covered by the dam structure 300 is further reduced.

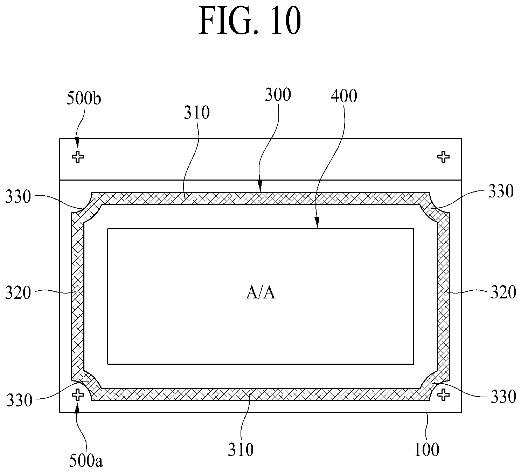

FIGS. 9 and 10 are schematic plan views of an organic light emitting display device. Except that a structure of a third dam structure 300c is a curve structure, the organic light emitting display device illustrated in FIGS. 9 and 10 is the same as the organic light emitting display device illustrated in FIG. 8.

The organic light emitting display device of FIG. 9 may be implemented by applying the third dam structure 300c of FIG. 6 to four edge areas, and the organic light emitting display device of FIG. 10 may be implemented by applying the third dam structure 300c of FIG. 7 to four edge areas.

The organic light emitting display device may be applied as various types, well known to those skilled in the art, such as a top emission type, a bottom emission type, etc.

As described above, since the align mark is disposed outside the dam structure, the align mark is not covered by the dam structure, and thus, the scribing process is smoothly performed.

The third dam structure is slopingly connected to each of the first and second dam structures, and the first align mark is disposed outside the third dam structure, thereby preventing the first align mark from overlapping the dam structure even without any increase in size of the non-display area. Accordingly, a bezel size of the organic light emitting display device is reduced, and moreover, the scribing process is smoothly performed.

## Claims

1. An organic light emitting display device comprising:
a substrate (100) including an active area and a non-display area provided outside the active area;
a dam structure (300) in the non-display area of the substrate and surrounding the active area, wherein the dam structure comprises:
a first dam structure (300a) extending in a first direction,
a second dam structure (300b) extending in a second direction, and
a third dam structure (300c) extending between and connecting the first dam structure and the second dam structure,
wherein the first dam structure and the second dam structure are arranged in parallel with outermost lines of the active area, and
the third dam structure is not arranged in parallel with the outermost lines of the active area; and
a first align mark (500a) disposed outside the dam structure in the non-display area of the substrate, the first align mark adjacent the third dam structure and **characterised in that** the first alignment mark (500a) is formed on or inward from an extension line of the first dam structure or an extension line of the second dam structure.

2. The organic light emitting display device of claim 1, wherein
the first dam structure comprises a first outer dam bank (320a), a first inner dam bank (330a), and a first sealant (310a) disposed between the first outer dam bank and the first inner dam bank,
the second dam structure comprises a second outer dam bank (320b), a second inner dam bank (330b), and a second sealant (310b) disposed between the second outer dam bank and the second inner dam bank,
the third dam structure comprises a third outer dam bank (320c), a third inner dam bank (330c), and a third sealant (310c) disposed between the third outer dam bank and the third inner dam bank,
one end of the third sealant is connected to the first sealant, and the other end of the third sealant is connected to the second sealant,
one end of the third outer dam bank is connected to the first outer dam bank, and the other end of the third outer dam bank is connected to the second outer dam bank, and
one end of the third inner dam bank is connected to the first inner dam bank, and the other end of the third inner dam bank is connected to the second inner dam bank.

3. The organic light emitting display device of claim 2, wherein a distance between the third inner dam bank and an outermost line of the active area is equal to or greater than a distance between the first inner dam bank and the outermost line of the active area.

4. The organic light emitting display device of claim 2 or claim 3, wherein at least one of the third outer dam bank and the third inner dam bank has a concave-convex structure.

5. The organic light emitting display device of claim 1, wherein the substrate comprises a pad area (P/A) in the non-display area, a second align mark (500b) is further provided in the pad area, and the dam structure is not disposed in the pad area.

6. The organic light emitting display device of claim 1, wherein the third dam structure has a rectilinear structure.

7. The organic light emitting display device of claim 1, wherein the third dam structure has a curved structure.

## Patentansprüche

1. Organische lichtemittierende Anzeigevorrichtung, umfassend:
ein Substrat (100), das einen aktiven Bereich und einen Nicht-Anzeigebereich außerhalb des aktiven Bereichs umfasst;
eine Dammstruktur (300) im Nicht-Anzeigebereich des Substrats, die den aktiven Bereich umgibt, wobei die Dammstruktur umfasst:
eine erste Dammstruktur (300a), die sich in einer ersten Richtung erstreckt,
eine zweite Dammstruktur (300b), die sich in einer zweiten Richtung erstreckt, und
eine dritte Dammstruktur (300c), die sich zwischen der ersten Dammstruktur und der zweiten Dammstruktur erstreckt und diese miteinander verbindet,
wobei die erste Dammstruktur und die zweite Dammstruktur parallel zu äußersten Linien des aktiven Bereichs angeordnet sind, und
die dritte Dammstruktur nicht parallel zu den äußersten Linien des aktiven Bereichs angeordnet ist; und
eine erste Justiermarke (500a), die außerhalb der Dammstruktur im Nicht-Anzeigebereich des Substrats angeordnet ist, wobei die erste Justiermarke benachbart zur dritten Dammstruktur und **dadurch gekennzeichnet ist, dass** die erste Justiermarke (500a) auf oder innerhalb einer Verlängerungslinie der ersten Dammstruktur oder einer Verlängerungslinie der zweiten Dammstruktur ausgebildet ist.

2. Organische lichtemittierende Anzeigevorrichtung nach Anspruch 1, wobei
die erste Dammstruktur einen ersten äußeren Dammwall (320a), einen ersten inneren Dammwall (330a) und ein erstes Dichtmittel (310a) umfasst, das zwischen dem ersten äußeren Dammwall und dem ersten inneren Dammwall angeordnet ist,
die zweite Dammstruktur einen zweiten äußeren Dammwall (320b), einen zweiten inneren Dammwall (330b) und ein zweites Dichtmittel (310b) umfasst, das zwischen dem zweiten äußeren Dammwall und dem zweiten inneren Dammwall angeordnet ist,
die dritte Dammstruktur einen dritten äußeren Dammwall (320c), einen dritten inneren Dammwall (330c) und ein drittes Dichtmittel (310c) umfasst, das zwischen dem dritten äußeren Dammwall und dem dritten inneren Dammwall angeordnet ist,
ein Ende des dritten Dichtmittels mit dem ersten Dichtmittel verbunden ist, und das andere Ende des dritten Dichtmittels mit dem zweiten Dichtmittel verbunden ist,
ein Ende des dritten äußeren Dammwalls mit dem ersten äußeren Dammwall verbunden ist, und das andere Ende des dritten äußeren Dammwalls mit dem zweiten äußeren Dammwall verbunden ist, und
ein Ende des dritten inneren Dammwalls mit dem ersten inneren Dammwall verbunden ist, und das andere Ende des dritten inneren Dammwalls mit dem zweiten inneren Dammwall verbunden ist.

3. Organische lichtemittierende Anzeigevorrichtung nach Anspruch 2, wobei ein Abstand zwischen dem dritten inneren Dammwall und einer äußersten Linie des aktiven Bereichs gleich wie oder größer als ein Abstand zwischen dem ersten inneren Dammwall und der äußersten Linie des aktiven Bereichs ist.

4. Organische lichtemittierende Anzeigevorrichtung nach Anspruch 2 oder 3, wobei mindestens einer des dritten äußeren Dammwalls und des dritten inneren Dammwalls eine konkav-konvexe Struktur aufweist.

5. Organische lichtemittierende Anzeigevorrichtung nach Anspruch 1, wobei
das Substrat einen Padbereich (P/A) im Nicht-Anzeigebereich umfasst,
ferner eine zweite Justiermarke (500b) im Padbereich vorgesehen ist, und
die Dammstruktur nicht im Padbereich angeordnet ist.

6. Organische lichtemittierende Anzeigevorrichtung nach Anspruch 1, wobei die dritte Dammstruktur eine geradlinige Struktur aufweist.

7. Organische lichtemittierende Anzeigevorrichtung nach Anspruch 1, wobei die dritte Dammstruktur eine gekrümmte Struktur aufweist.

## Revendications

1. Afficheur électroluminescent organique comprenant :
un substrat (100) comprenant une zone active et une zone de non-affichage prévue à l'extérieur de la zone active ;
une structure de barrage (300) dans la zone de non-affichage du substrat et entourant la zone active, la structure de barrage comprenant :
une première structure de barrage (300a) s'étendant dans une première direction,
une deuxième structure de barrage (300b) s'étendant dans une deuxième direction, et
une troisième structure de barrage (300c) s'étendant entre et reliant la première structure de barrage et la deuxième structure de barrage,
la première structure de barrage et la deuxième structure de barrage étant agencées en parallèle avec les lignes les plus extérieures de la zone active, et
la troisième structure de barrage n'étant pas agencée parallèlement aux lignes les plus extérieures de la zone active ; et
une première marque d'alignement (500a) disposée à l'extérieur de la structure de barrage dans la zone de non-affichage du substrat, la première marque d'alignement étant adjacente à la troisième structure de barrage et **caractérisée en ce que** la première marque d'alignement (500a) est formée sur ou vers l'intérieur d'une ligne d'extension de la première structure de barrage ou d'une ligne d'extension de la deuxième structure de barrage.

2. Afficheur électroluminescent organique selon la revendication 1,
la première structure de barrage comprenant une première rive de barrage externe (320a), une première rive de barrage interne (330a), et un premier agent d'étanchéité (310a) disposé entre la première rive de barrage externe et la première rive de barrage interne,
la deuxième structure de barrage comprenant une deuxième rive de barrage externe (320b), une deuxième rive de barrage interne (330b), et un deuxième agent d'étanchéité (310b) disposé entre la deuxième rive de barrage externe et la deuxième rive de barrage interne,
la troisième structure de barrage comprenant une troisième rive de barrage externe (320c), une troisième rive de barrage interne (330c) et un troisième agent d'étanchéité (310c) disposé entre la troisième rive de barrage externe et la troisième rive de barrage interne,
une extrémité du troisième agent d'étanchéité étant reliée au premier agent d'étanchéité, et l'autre extrémité du troisième agent d'étanchéité étant reliée au deuxième agent d'étanchéité,
une extrémité de la troisième rive de barrage externe étant reliée à la première rive de barrage externe, et l'autre extrémité de la troisième rive de barrage externe étant reliée à la deuxième rive de barrage externe, et
une extrémité de la troisième rive de barrage interne étant reliée à la première rive de barrage interne, et l'autre extrémité de la troisième rive de barrage interne étant reliée à la deuxième rive de barrage interne.

3. Afficheur électroluminescent organique selon la revendication 2, une distance entre la troisième rive de barrage interne et une ligne la plus extérieure de la zone active étant égale ou supérieure à une distance entre la première rive de barrage interne et la ligne la plus extérieure de la zone active.

4. Afficheur électroluminescent organique selon la revendication 2 ou selon la revendication 3, au moins l'une de la troisième rive de barrage externe et de la troisième rive de barrage interne ayant une structure concave-convexe.

5. Afficheur électroluminescent organique selon la revendication 1, le substrat comprenant une zone de plage (P/A) dans la zone de non-affichage, une seconde marque d'alignement (500b) étant en outre prévue dans la zone de plage, et la structure de barrage n'étant pas disposée dans la zone de plage.

6. Afficheur électroluminescent organique selon la revendication 1, la troisième structure de barrage ayant une structure rectiligne.

7. Afficheur électroluminescent organique selon la revendication 1, la troisième structure de barrage ayant une structure incurvée.
